# EUROPEAN PATENT SPECIFICATION

(11) **EP 0 398 087 B1**
(45) Date of publication and mention of the grant of the patent: **26.07.1995**
(21) Application number: 90108426.9
(22) Date of filing: 04.05.1990
(51) Int. Cl.: H04B 1/59, G08C 19/00, G01R 19/04, H03B 11/04, G01S 13/02

(54) **Circuit arrangement for generating a control signal in dependence upon the occurrence of an extreme value of a sinusoidal oscillation and use of such a circuit arrangement**
Schaltung zur Erzeugung eines Steuersignals bei dem Auftritt eines Spitzenwertes einer sinusförmigen Schwingung, und Anwendung einer solchen Schaltung
Circuit pour générer un signal de contrôle en dépendence d'une valeur extrême d'une oscillation sinusoidale et utilisation d'un tel circuit.

(30) Priority: 05.05.1989 DE 3914888
(43) Date of publication of application: 22.11.1990
(73) Proprietor: TEXAS INSTRUMENTS DEUTSCHLAND GMBH, 85356 Freising (DE)
(72) Inventor: Steinhagen, Wolfgang, D-8054 Mauern (DE); Kaiser, Ulrich, D-4788 Warstein 2 (DE)
(74) Representative: Schwepfinger, Karl-Heinz, Dipl.-Ing.

(56) References cited:
- EP-A- 0 301 127
- CH-A- 513 548
- FR-A- 2 132 208
- FR-A- 2 176 521

## Description

The invention relates to a circuit arrangement of the type defined in the precharacterizing part of claim 1.

A resonance circuit has the property that after stimulation with its resonant frequency it continues to oscillate even when the excitation energy is no longer supplied. Since the components of the resonance circuit have however losses and the further components connected thereto can also effect a damping, as a rule the oscillation decays aperiodically very rapidly unless energy is again supplied to the resonance circuit which is at least high enough to compensate the attenuation losses. The energy supply must take place at the correct instant in order to act in the sense of a self-excitation and maintain the oscillation. Consequently, there is a need for a circuit arrangement which can generate a control signal with the aid of which the energy supply to a resonance circuit can be effected with the objective of maintaining the oscillations thereof.

The invention is therefore based on the problem of providing a circuit arrangement of the type mentioned at the beginning with the aid of which without high circuit expenditure such a control signal can be generated and used in a relatively large frequency range of the sinusoidal oscillation.

This problem is solved according to the invention by providing the circuit arrangement defined above with the features of the characterizing part of claim 1.

From FR-A-2176521 a circuit arrangement is known which is suitable for generating a signal in dependence on the occurance of an extreme value of an input signal. This circuit arrangement is provided with a charge circuit for charging a storage member via a diode, and it further comprises a discharge path for discharging said storage member. However, the amplifier-comparator which provides the aforementioned signal is not enabled by conduction of the charge circuit.

With the circuit arrangement according to the invention at one of the extreme values of a sinusoidal oscillation a respective pulse can be generated and this relationship is maintained over a relatively large range of the sinusoidal oscillations.

A preferred use of the circuit arrangement according to the invention is characterized in subsidiary claim 3. In this use a resonance circuit stimulated to oscillate with the aid of a momentary HF carrier wave pulse is always supplied with the energy it requires for further oscillation in that the control signal generated closes a switch via which the energy supply to the resonance circuit can take place in-phase in each case. Since the control signal is generated at an extreme value of the sinusoidal oscillation the energy supply is necessarily in-phase so that actually an energy supply to the resonance circuit results in the sense of a self-excitation. EP-A-0 301 127 shows a periodically stimulated resonance circuit in a transponder.

An advantageous further development of the use of the circuit arrangement according to the invention is characterized in subsidiary claim 4. In this further development the resonance circuit is part of a transponder in which the oscillations of the resonance circuit are used to generate clock signals controlling the function sequence in the transponder. The special feature here is that the transponder does not have its own supply voltage source but is provided merely with a storage capacitor which is charged by rectification of the HF carrier frequency pulse which also stimulates the resonance circuit to oscillate. Immediately after termination of the HF carrier wave pulse the circuit arrangement according to the invention starts the generation of the control signals in dependence on one of the extreme values of the sinusoidal oscillation in the resonance circuit and with the aid of the control signals generated energy is then supplied to the resonance circuit from the storage capacitor and this is continued until the energy in the storage capacitor is used up. This period is utilized for transmitting a message stored in the transponder to a receiving apparatus under the control of the clock signals derived from the sinusoidal oscillation of the resonance circuit.

The invention will now be explained by way of example with the aid of the drawings, wherein:
- Fig. 1: is a circuit diagram of the circuit arrangement according to the invention and
- Fig. 2: is a basic circuit diagram to explain an example of use of the circuit arrangement according to the invention.

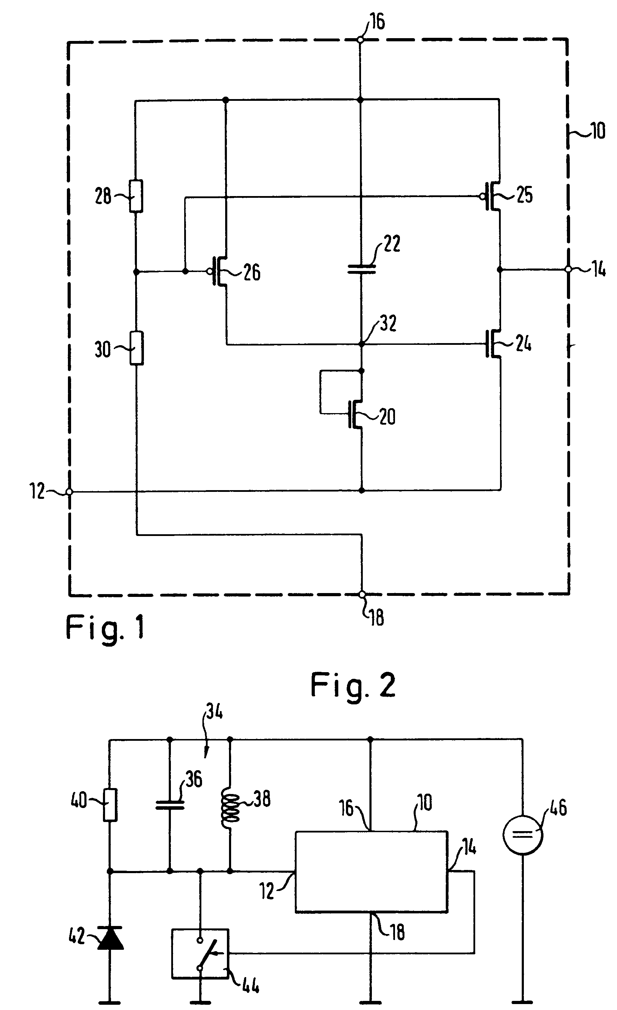

The circuit arrangement 10 illustrated in Figure 1 comprises an HF input 12 to which in operation a sinusoidal oscillation is applied. It also comprises an output 14 at which it can furnish a control signal. A terminal 16 serves as supply voltage terminal and an input 18 serves as ground terminal.

The HF input 12 is connected via a field-effect transistor 20 connected as diode to one plate of a capacitor 22 which acts as storage member as will be explained hereinafter. The other plate of said capacitor 22 is connected to the supply voltage terminal 16. In addition, the HF input 12 is in connection with two series-connected source-drain paths of two further field-effect transistors 24, 25 leading to the supply voltage terminal 16. The connection between the two source-drain paths of the field-effect transistors 24, 25 forms the output 14. The field-effect transistor 20 connected as diode is connected to the gate electrode of the field-effect transistor 24 and to the drain electrode of a further field-effect transistor 26, the source electrode of which is connected to the supply voltage terminal 16 whilst the gate electrode thereof is connected to the gate electrode of the field-effect transistor 25. Also connected to the gate electrode of the field-effect transistor 26 is the connection point of two resistors 28, 30 which are connected in series between the supply voltage terminal 16 and the ground terminal 18.

The field-effect transistors 20 and 24 contained in the circuit arrangement of Figure 1 are N-channel MOS field-effect transistors and the field-effect transistors 25, 26 are P-channel MOS field-effect transistors.

Due to their connection to the voltage divider comprising the resistors 28 and 30 the field-effect transistors 25 and 26 are applied to a fixed bias voltage and act as constant current sources; the field-effect transistor 25 acts as load resistance for the field-effect transistor 24.

The circuit arrangement of Figure 1 operates as follows: When a sinusoidal oscillation or sine wave is applied to the HF input 12 the circuit point 32 follows the sinusoidal oscillation until its minimum is reached. As soon as the sinusoidal oscillation starts to rise again the blocking action of the field-effect transistor 20 comes into play so that the circuit point 32 is held at the potential of the minimum of the sinusoidal oscillation. The capacitor 22 acts as storage member for said potential of the minimum of the sinusoidal oscillation. Via the field-effect transistor 26, which is connected in parallel with the capacitor 22 and as already mentioned acts as current source, a discharge of the capacitor 22 takes place, the discharge time constant being set by means of the voltage divider comprising the resistors 28 and 30 in such a manner that within the period duration of the sinusoidal oscillation an appreciable discharge of the storage member takes place, i.e. the potential at the circuit point 32 is changed in positive direction.

As soon as the sinusoidal oscillation at the HF input 12 again approaches its minimum and in particular again reaches a voltage value which is lower than the potential at the circuit point 32 (apart from the threshold voltage at the field-effect transistor 20 connected as diode) the field-effect transistor 20 again becomes conductive so that a charging current flows to the capacitor 22 and as a result the potential at the circuit point 32 is again drawn to the minimum of the sinusoidal oscillation. The short current pulse which flows for recharging of the capacitor 22 results in the field-effect transistor 24 changing to the conductive state for the duration of said current pulse and consequently at the output 14 a negative pulse appears which is clearly related to the minimum of the sinusoidal oscillation at the HF input 12.

A preferred use of the circuit arrangement of Figure 1 is indicated in Fig. 2 by a schematic circuit diagram.

The circuit illustrated in Fig. 2 is part of a transponder of which however only the components necessary for the explanation of the use of the circuit arrangement of Figure 1 are shown. The resonance circuit 34 contained in the circuit of Figure 2 and comprising the capacitor 36 and coil 38 can be stimulated to oscillate by means of an HF carrier wave pulse emitted by a transmitting device. Said pulse may be received by an antenna, not shown in Fig. 2, and supplied to the resonance circuit; however, only the coil 38 can be part of the antenna. The resistor 40 lying parallel to the resonance circuit 34 is shown as representative of all elements damping the resonance circuit 32.

A diode 42 leads from the parallel circuit of the resistor 40, the capacitor 36 and the coil 38 to ground. Parallel to the diode there is a switch 44 which can be closed by the control signal from the circuit arrangement 10. In practice the switch 44 is an electronic switch which on receiving the control signal from the output 14 moves from the nonconductive state to the conductive state.

In Figure 2 a supply voltage source 46 is illustrated which in the use outlined in a transponder may consist of a capacitor which is charged by rectification of the HF carrier wave pulse by means of the diode 42. The voltage at the capacitor 46 serves as supply voltage for the circuit arrangement 10 and serves simultaneously as energy source from which the resonance circuit 34 under the control of the control signal from the circuit arrangement 10 on each closure of the switch 44 receives an energy pulse which maintains the sinusoidal oscillation in the resonance circuit 34. Of course, it is only possible to maintain the sinusoidal oscillations for a limited period of time which depends on the size of the capacitor 46 and the energy stored therein.

The circuit arrangement 10 generates the control signal at the output 14 always in the region of the minimum of the sinusoidal oscillations in the resonance circuit 34 and consequently the closing of the switch also takes place in this region. This leads to in-phase energy supply to the resonance circuit which is a prerequisite for maintenance of the sinusoidal oscillations.

It is pointed out that the circuit arrangement illustrated in Figure 1 can readily be modified so that it generates control signals in the region of the maximum of the sinusoidal oscillations. To do this, it would merely be necessary to use P-channel MOS transistors instead of the respective N-channel MOS field-effect transistors used and vice-versa. The use circuit of Figure 2 could also readily be adapted to another polarity of the control signal from the circuit arrangement 10.

## Claims

1. Circuit arrangement for generating a control signal in dependence upon the occurrence of an extreme value of a sinusoidal oscillation, comprising a storage member (22) which is adapted to be charged via a diode (20) to one of the extreme values of the sinusoidal oscillation, a discharge path for the storage member (22), the time constant of which is so dimensioned that within the time period duration of the sinusoidal oscillation an appreciable discharge of the storage member takes place, characterized by a switch element (24) which is enabled via conduction of said diode (20) for the time duration during which the charge voltage is less than the value of the sinusoidal voltage, and which furnishes the control signal at its output (14) during said time.

2. Circuit arrangement according to claim 1, characterized in that the switch element is a field-effect transistor (24) to the gate electrode of which the charging voltage at the storage member (22) is applied, to the source electrode of which the sinusoidal oscillation is supplied and the drain electrode of which is in connection with a constant current source (25) acting as load resistance.

3. Use of the circuit arrangement according to claim 1 or 2 for maintaining the oscillations of a resonance circuit comprising a coil and capacitor, the resonance circuit being stimulated to oscillate by means of a momentary HF carrier wave pulse, characterized in that the resonance circuit (34) lies in series connection with a controllable switch (44) which in turn is connected in parallel with a supply voltage source (46) and that the switch (44) can be shifted by the control signal furnished by the switch element (24) to the closed state in which it applies the output voltage of the supply voltage source (46) to the resonance circuit.

4. Use according to claim 3, characterized in that the coil (38) of the resonance circuit (34) is the receiving coil in the receiving section of a transponder of which the supply voltage source is formed by a capacitor which is charged by rectification of the HF carrier wave pulse received by the coil (38) of the resonance circuit (34), and that the oscillations of the resonance circuit after termination of the HF carrier wave pulse serve to generate clock pulses in the transponder.

## Patentansprüche

1. Schaltungsanordnung zum Erzeugen eines Steuersignals in Abhängigkeit vom Auftreten eines Extremwerts einer Sinusschwingung, mit einem Speicherglied (22), das über eine Diode auf einen der Extremwerte der Sinusschwingung aufladbar ist, einem Entladeweg für das Speicherglied (22), dessen Zeitkonstante so bemessen ist, daß innerhalb der Periodendauer der Sinusschwingung eine merkliche Entladung des Speicherglieds (22) erfolgt, gekennzeichnet durch ein Schaltelement (24) , das durch den leitenden Zustand der Diode (20) für die Zeitdauer, während der die Ladespannung kleiner als der Wert der Sinusschwingung ist, wirksam ist und das während dieser Zeitdauer an seinem Ausgang (14) das Steuersignal abgibt.

2. Schaltungsanordnung nach Anspruch 1, dadurch gekennzeichnet, daß das Schalterelement ein Feldeffekttransistor (24) ist, an dessen Gate-Elektrode die Ladespannung am Speicherglied (22) anliegt, dessen Source-Elektrode die Sinusschwingung zugeführt wird und dessen Drain-Elektrode mit einer als Lastwiderstand wirkenden Konstantstromquelle (25) in Verbindung steht.

3. Anwendung der Schaltungsanordnung nach Anspruch 1 oder 2 zum Aufrechterhalten der Schwingungen eines mittels eines kurzzeitigen HF-Trägerschwingungsimpulses zum Schwingen angeregten Resonanzkreises mit einer Spule und einem Kondensator, dadurch gekennzeichnet, daß der Resonanzkreis (34) in einer Serienschaltung mit einem steuerbaren Schalter (44) liegt, die ihrerseits parallel zu einer Versorgungsspannungsquelle (46) geschaltet ist, und daß der Schalter (44) durch das von dem Schalterelement (24) abgegebene Steuersignal in den geschlossenen Zustand versetzbar ist, in dem es die Ausgangsspannung der Versorgungsquelle (46) an den Resonanzkreis anlegt.

4. Anwendung nach Anspruch 3, dadurch gekennzeichnet, daß die Spule (38) des Resonanzkreises (34) die Empfängerspule im Empfängerteil eines Transponders ist, dessen Versorgungsspannungsquelle von einem Kondensator gebildet ist, der durch Gleichrichten des von der Spule (38) des Resonanzkreises (34) empfangenen HF-Trägerschwingungsimpulses aufgeladen wird, und daß die Schwingungen des Resonanzkreises nach Beendigung des HF-Trägerschwingungsimpulses der Erzeugung von Taktimpulsen in dem Transponder dienen.

## Revendications

1. Circuit pour générer un signal de commande sous la dépendance de l'occurrence d'une valeur extrême d'une oscillation sinusoïdale, comprenant un élément de stockage (22) adapté pour être chargé par l'intermédiaire d'une diode (20) à l'une des valeurs extrêmes de l'oscillation sinusoïdale, un trajet de décharge pour l'élément de stockage (22), la constante de temps de l'élément de stockage étant dimensionnée de telle sorte qu'une décharge appréciable de l'élément de stockage se produit pendant la durée de l'oscillation sinusoïdale, caractérisé en ce qu'il comprend un élément de commutation (24) qui est validé par la conduction de ladite diode (20) pendant la durée durant laquelle la tension de charge est inférieure à la valeur de la tension sinusoïdale, et qui fournit le signal de commande à sa sortie (14) durant ladite durée.

2. Circuit selon la revendication 1, caractérisé en ce que l'élément de commutation est un transistor à effet de champ (24) à l'électrode de grille duquel la tension de charge est appliquée à l'élément de stockage (22), à l'électrode de source duquel l'oscillation sinusoïdale est appliquée et à l'électrode de drain duquel est reliée une source (25) de courant constant agissant comme une résistance de charge.

3. Utilisation d'un circuit selon l'une des revendications 1 et 2 pour maintenir les oscillations d'un circuit résonant comprenant une bobine et un condensateur, le circuit résonant étant excité de manière à osciller au moyen d'une impulsion d'onde porteuse à haute fréquence momentanée, caractérisée en ce que le circuit résonant (34) est relié en série avec un commutateur commandable (44) qui est à son tour relié en parallèle sur une source de tension d'alimentation (46) et en ce que le commutateur (44) peut être commuté par le signal de commande fourni par l'élément de commutation (24) à l'état fermé dans lequel il applique la tension de sortie de la source de tension d'alimentation (46) aux circuits résonants.

4. Utilisation selon la revendication 3, caractérisé en ce que la bobine (38) du circuit résonant (34) est la bobine réceptrice dans la partie réceptrice d'un répéteur dont la source de tension d'alimentation est formée par un condensateur qui est chargée par le redressement d'une impulsion d'onde porteuse à haute fréquence reçue par la bobine (38) du circuit résonant (34), et en ce que les oscillations du circuit résonant après l'achèvement de l'impulsion d'onde à haute fréquence sert pour générer des impulsions d'horloge dans le répéteur.
